Europäisches Patentamt

European Patent Office

Office européen des brevets

(11) Publication number: **0 294 201**
**A2**

# EUROPEAN PATENT APPLICATION

(21) Application number: 88305046.0

(22) Date of filing: 02.06.88

(51) Int. Cl.⁴: **G 09 B 5/04**

(30) Priority: 05.06.87 JP 140915/87
05.06.87 JP 140917/87

(43) Date of publication of application:
07.12.88 Bulletin 88/49

(84) Designated Contracting States: **DE FR GB IT SE**

(71) Applicant: **KABUSHIKI KAISHA TOSHIBA**
**72, Horikawa-cho Saiwai-ku**
**Kawasaki-shi Kanagawa-ken 210 (JP)**

**TOSHIBA AUDIO VIDEO ENGINEERING CO., LTD.**
**3-9-9, Shinbashi 3-chome Minato-ku**
**Tokyo (JP)**

(72) Inventor: **Yamamoto, Takaharu 837-5, Kita Kawahara**
**Inokoshihara Idaka-cho**
**Meito-ku Nagoya (JP)**

**Hashiba, Syuzi§Toshiba Narumi Ryo Dormitory**
**43, Aza Denjiyama Narumi-cho**
**Midori-ku Nagoya (JP)**

**Imai, Toshimitsu Toshiba Meisei**
**Ryo Dormitory 33-10 Kodama 3-chome**
**Nishi-ku Nagoya (JP)**

(74) Representative: **Freed, Arthur Woolf et al**
**MARKS & CLERK 57-60 Lincoln's Inn Fields**
**London WC2A 3LS (GB)**

(54) Digital sound data storing device.

(57) This invention relates to a digital sound data storing deivce in which analog signals are obtained from digital sound data. The digital sound data storing device includes a case (1) enclosing a reproduction unit (1a) and an IC card (8) detachably attached to the case (1). A plurality of digital sound data groups are stored at a built-in IC memory (9) of the IC card (8). The sound data groups are obtained, for example, by recording short sentences for practicing foreign language conversation, through a microphone to obtain analog sound signals and digitizing the analog sound signals. When the IC card (8) is attached to the case (1), a sound synthesis circuit (14) enclosed in the case (1) reads out the sound data groups and converts the digital sound data groups to analog signals, which are amplified to be reproduced as sound groups. When any one of push buttons (2a) disposed on the case (1) is depressed to input an identification code corresponding to any sound desired or not desired to be reproduced, data of the identification code is inputted in the built-in memory (9). Based on the data of the identification code, the sound groups are selectively reproduced or selectively excluded from the sound groups to be reproduced.

Fig. 1

EP 0 294 201 A2

**Description**

## DIGITAL SOUND DATA STORING DEVICE

The present invention relates to a sound data storing device wherein sound is reproduced based on digitized sound data stored therein and which is portable and especially suitable for language speaking practice.

Cassette tape recorders have been well known as the above-mentioned type of sound data storing device. In the cassette tape recorder, for example, analog human speech signals are magnetically recorded on a megnetic tape taken up in a case. Speech signals are read out by running the magnetic tape with the tape coming into contact with a magnetic head, thereby reproducing speech.

The cassette tape recorder is useful in continuously reproducing the speech or sound data groups recorded throughout the tape. However, a user or learner is forced into troublesome operations of the cassette tape recorder when a part of recorded speech or sound data groups is to be reproduced. That is, a part of tape corresponding to any speech group not desired to be reproduced must be quickly skipped over until the tape reaches the part corresponding to the speech group desired to be reproduced by the learner and the tape recorder is then operated in the reproduction mode as usual. Accordingly, when reproduction of any of a plurality of short sentences recorded for language speaking practice, for example, needs to be repeated a user or learner is forced into troublesome operations of quickly running the tape forwardly and backwardly to thereby seach the part desired to be reproduced. Further, when some of the sentences are already memorized by the learner and accordingly, the sentences are reproduced with the memorized sentences skipped over, the learner is also forced into troublesome operations of the tape recorder as mentioned above. Such troublesome operations of the tape recorder prevent the learner from concentrating on the memorizing work and are not desirable for the language speaking practice.

Therefore, a primary object of the present invention is to provide a digital sound data storing device wherein a desirable part of stored sound data can be reproduced with easy operation of the device.

A second object of the present invention is to provide a digital sound data storing device wherein the sound can be sequentially reproduced with any of sound groups skipped over with easy operation of the device.

In order to attain the primary object, the digital sound data storing device in accordance with this invention comprises a case and a card-shaped external storage unit detachably attached to the case. The external storage unit has an integrated circuit memory which stores a plurality of digitized sound data groups corresponding to a plurality of sound groups. The case encloses a reproduction unit comprising a sound synthesis circuit synthesizing analog signals from the sound data groups read out from the IC memory of the external storage unit, an amplifying circuit amplifying the analog sound signals synthesized by the sound synthesis circuit, and output means for reproducing sound from the analog sound signals amplified by the amplifying circuit so that sound is reproduced based on the sound data groups stored in the IC memory. The reproduction unit further comprises input means for inputting identification codes corresponding to the respective sound groups desired to be reproduced, internal storage means for storing a reproduction information with respect to each sound data group corresponding to each identification code inputted by the user at the input means, and selective reproduction control means for controlling the sound synthesis circuit so that the sound data groups indicated by the reproduction information stored at the internal storage means are sequentially synthesized to analog sound signals.

According to the above described construction, the sound groups corresponding to the repspective identification codes inputted by the user at the input means are sequentially synthesized to the respective sound groups, which are sequentially reproduced.

In order to attain the second object, the digital sound data storing device of this invention includes input means for inputting identification codes with respect to the sound groups undesired to be reproduced, instead of the above-described input means. The selective reproduction control means is arranged to control the sound synthesis circuit so that the sound data groups stored at the IC memory of the external storage unit are sequentially read out in a continuous reproduction mode and are sequentially converted to analog sound signals and so that the sound groups are synthesized in the continuous reproduction mode based on the sound data groups except that or those set by the input means.

According to the above-described construction. the sound groups are reproduced except that or those corresponding to the identification code or codes inputted by the user at the input means.

Embodiments of the invention will not be described, by way of example, with reference to the accompanying drawings, in which:

Fig. 1 is a block diagram illustrating the electrical arrangement of a first embodiment of the digital sound data storing device in accordance with this invention;

Fig. 2 is a perspective view illustrating the digital sound data storing device with the external storage unit detached from the case of the device;

Fig. 3 illustrates an address map of the IC memory incorporated in the external storage unit;

Fig. 4 illustrates an address map of the internal memory; and

Fig. 5 illustrates an address map of the internal memory employed in the digital sound data storing device of a second embodiment in accordance with this invention.

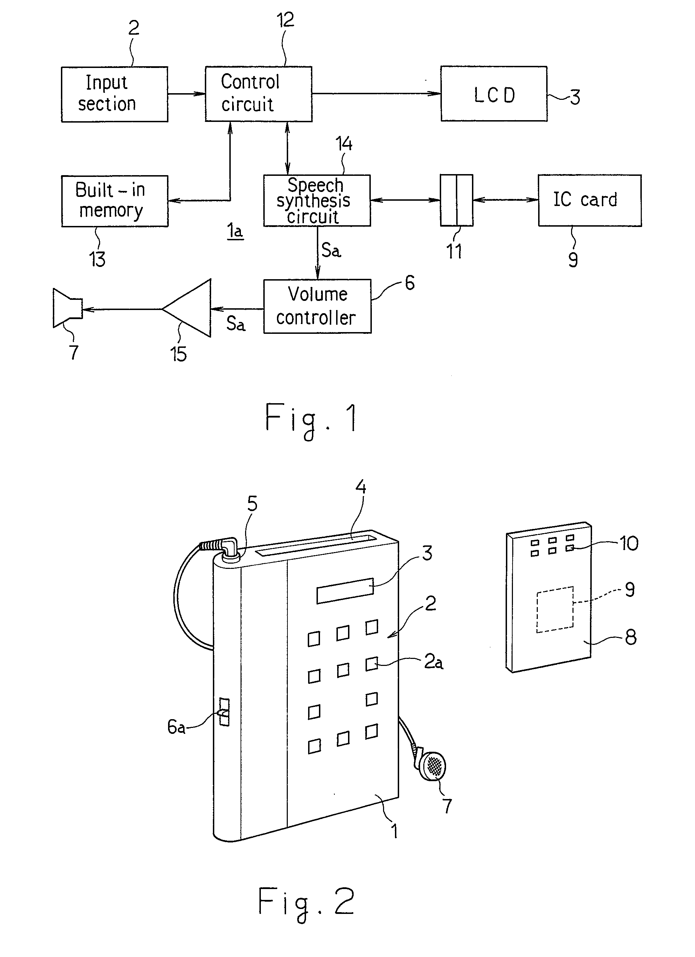

Figs. 1-4 illustrate a first embodiment in which the digital sound data storing device in accordance with this invention is applied to a portable language speaking trainer.

Referring first to Fig. 2, a flat box-shaped case 1 encloses a reproduction unit 1a which will be described hereinafter and has an input section 2 provided on the front side thereof. The input section 2 includes a plurality of push-buttons 2a. A liquid crystal display 3, which will be hereinafter referred to as LCD, is also provided on the front side of the case 1. A card insertion opening 4 is formed in the upper side of the case 1 and an earphone jack 5 is provided in the upper side thereof, as viewed in Fig. 2. Further, a volume control knob 6a of a volume controller or variable resistor 6 is provided on the left side of the case 1, as viewed in Fig. 2. Reference numeral 7 indicates an earphone as reproduction means connected to the earphone jack 5.

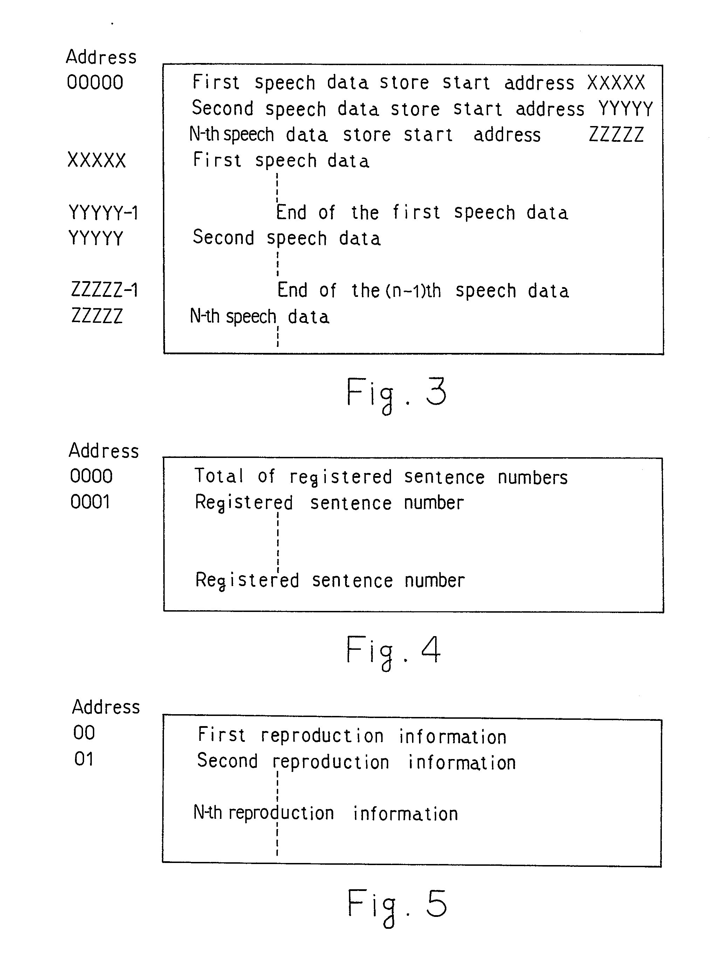

An integrated circuit (IC) card 8 serving as an external storage unit is insertable into and detachable from the insertion opening 4. The IC card 8 includes an IC memory for read only use or a programmable read only memory (PROM) chip 9 embedded therein. N number of digitized speech data groups are assigned addresses in the IC memory 9, respectively, as shown by the address map of Fig. 3. Each speech data group represents a short sentence of a foreign language to be learned, for example. The speech is recorded through a microphone to obtain analog speech signals, which are converted to digital speech signals in accordance with a conventional manner of digitizing speech. As shown in Fig. 3, initial memory addresses of n number of speech data groups corresponding to first to n sentences are assigned predetermined storage areas starting with an address (00000) at the IC memory 9. The other storage areas of the IC memory 9 are assigned digital speech data groups. A plurality of contacts 10 for inputting and outputting signals are provided on one side of the IC card 8. When the IC card 8 is inserted in the insertion opening 4, the contacts 10 are connected to a connector 11 provided within the case 1.

Referring now to Fig. 1 showing an electrical arrangement of the reproduction unit 1a and the IC card 8, a control circuit 12 includes a central processing unit (CPU). A built-in memory 13 serving as an internal stroage means comprises a random access memory (RAM). A speech synthesis circuit 14 comprises a digital-to-analog (D/A) converter. Such a speech synthesis circuit is generally arranged so as to convert digital signals to analog signals. The basic arrangement of the speech synthesis circuit is well known in sound response techniques in the field of computer or digital audio techniques in the laser compact disc. The speech synthesis circuit 14 employed in the language speaking trainer of the first embodiment sequentially reads out the digitized speech data groups addressed by the control circuit 12 from the IC memory 9 of the IC card 8. Based on the digital speech data groups read out from the IC memory 9, the speech synthesis circuit 14 performs a digital-to-analog conversion operation to thereby output analog speech signals Sa. Upon completion of the D/A conversion operation. the speech synthesis circuit 14 generates a completion signal which is supplied to the control circuit 12 in a feedback manner. In accordance with instructions inputted by a user at the input section 2 and control program prestored therein, the control circuit 12 performs the data transmission between it and the built-in memory 13 and controls the LCD 3 and the speech synthesis circuit 14 in the manner which will be hereinafter described. In addition to the above-described functions, the control circuit 12 serves as a selective reproduction means for selectively reproducing particular speech groups out of a plurality of speech data groups stored in the IC memory 9, based on the data prestored at the built-in memory 13. As shown in Fig. 4, the built-in memory 13 is capable of storing identification codes corresponding to the respective speech data groups assigned addresses (0001) to (nnnn). Serial numbers 1-n are employed as identification codes in the embodiment. When any push button 2a of the input section 2 is depressed to input the serial number of the speech group desired to be reproduced, data of the serial number is stored at the built-in memory 13. Data of a total number of the identification codes is stored at the built-in memory 13 with the total number assigned an address (0000) and stored at the built-in memory 13.

Reference numeral 15 indicates an amplifying circuit for amplifying the analog signals Sa synthesized by the speech synthesis circuit 14. More specifically, the analog speech signals Sa are supplied from the speech synthesis circuit 14 to the amplifying circuit 15 through the volume controller 6. The analog speech signals Sa amplified by the amplifying circuit 15 are supplied to the earphone 7. Accordingly, when the analog speech signals Sa are produced by the speech synthesis circuit 14, the speech groups corresponding to the analog speech signals Sa are outputted from the earphone 7, thereby reproducing the speech groups. The volume may be controlled by the volume controller 6 with the knob 6a.

The control operation of the control circuit 12 will now be described together with overall operation of the language speaking trainer. One of the push buttons 2a of the input section 2 is depressed so that a continuous reproduction mode is selected. Subsequently, the identification codes of the desired speech groups are sequentially inputted by the learner at the input section 2 and any one of FORWARD and REVERSE reproduction modes is alternatively selected, thereby starting the reproduction operation. The control circuit 12 supplies the speech synthesis circuit 14 with data of the identification codes starting with the one inputted at the input section 2 and sequentially going forwardly in the case of the FORWARD reproduction mode or sequentially going reversely in the case of the REVERSE reproduction mode. Every time the speech synthesis circuit 14 is supplied with an identification code, the speech synthesis circuit 14 accesses the address of the area of the IC memory 9 corresponding to the identification code supplied thereto. thereby reading out the digitized speech data groups sequentially. The speech synthesis circuit 14 performs the operation of synthesizing the analog speech signals Sa corresponding to the digitized speech data groups and supplies the amplifying circuit 15 with analog speech signals Sa. The speech groups corresponding to the analog speech signals Sa are sequentially outputted from the earphone 7. As a results the speech data groups represented by the respective identification codes starting with the one inputted by the learner at the input section 2 are sequentially reproduced once.

When a selective reproduction mode is set by depression of any push-button 2a, one or a plurality of identification codes representing the speech data groups desired to be reproduced and the number of times of repeat operations are inputted by depression of one of the push buttons 2a of the input section 2. The control circuit 12 performs the operation of storing data of the identification codes inputted and the number of times of the repeat operations at the built-in memory 13 sequentially and of displaying the data on the LCD 3. Further, the control circuit 12 firstly supplies the speech synthesis circuit 14 with the initial identification codes. The speech synthesis circuit 14 reads out the speech data groups corresponding to the identification codes inputted from the IC memory 9 of the IC card 8, thereby converting the speech data groups read out to analog speech signals Sa. The analog speech signals Sa are then supplied to the amplifying circuit 15 and outputted from the earphone 7. When the speech reproduction is completed, a completion signal is supplied from the speech synthesis circuit 14 to the control circuit 12 in the feedback manner. The control circuit 12 operates to reiterate the output of the identification code inputted to thereby repeat reproduction of the speech group. Upon completion of the reproduction operations of the speech group by the number of times set, the control circuit 12 operates to access the next address (0002) in the built-in memory 13 and read out the identification code set next therefrom, data of the identification code being supplied to the speech synthesis circuit 14. The speech data group represented by the identification code is reiteratively reproduced by the number of times set as in the foregoing speech group. Thus, data of all the identification codes stored at the built-in memory 13 is read out by the control circuit 12 and the speech data groups represented by the respective identification codes are reproduced in the order that the identification codes are inputted to the speech synthesis circuit 14.

Since any desired speech data group or sentence selected from a plurality of speech data groups or sentences may reiteratively reproduced. the language speaking trainer of the embodiment is suitable for the intensive practice in speaking a foreign language. Further, since any desired speech data group or groups may be selected from a plurality of speech data groups and reiteratively reproduced, the learning efficiency may be improved. Moreover, since the order in which the speech data groups are reproduced may be changed, the learning efficiency may be further improved. Since the digitized speech data groups are stored in the IC memory 9, a complicated mechanism such as required in the device of the magnetic recording type is denecessitated in the language speaking trainer of the embodiment. Consequent ly, occurrence of failure may be reduced and the electrical power consumption may be decreased together with the decrease of the net weight of the device. As a result, life of the device may be lengthened and reliability thereof may be improved. When batteries are used as a power supply for the purpose of carrying the device or for other purposes, the time period of continuous operation of the device may be increased and the portability of the device may be improved. Furthermore, since the data destruction owing to magnetic force need not be taken into consideration with respect to the IC memory 9, the IC card 8 may be manipulated with ease. Since the small-sized thin IC card 8 is employed as the external storage unit, portability of the language speaking trainer may be further improved.

The language speaking trainer of a second embodiment in accordance with this invention will now be described. The basic construction of the hardware in the first embodiment as shown in Fig. 1 is also employed in the second embodiment. The second embodiment differs from the previous embodiment in the arrangement of the software of the control circuit 12. Accordingly, the identical parts are labelled by the same reference numerals as in the first embodiment and those identical parts will not be described in detail.

Referring first to Fig. 5, the built-in memory 13 is provided with areas for storing reproduction prohibition codes as reproduction information in addresses correspond ing to the identification codes (1-n) in the one by one relation so that the reproduction prohibition signal. more specifically either logic level 1 or 0, is stored in the area assigned addresses corresponding to the speech data groups selected by depression of the push buttons 2a of the input section 2. That is, when data of identification codes of any sentences undesired to be reproduced is inputted by depression of the push button 2a of the input section 2, the control circuit 12 operates to store the reproduction prohibition code at the area assigned the addresses corresponding to the identification codes of the sentences inputted.

The control circuit 12 is further programmed so as to perform the control operation in the following manner. In the case that a random selection mode is set by depression of any one of the push buttons 2a of the input section 2, identification codes of the speech data groups desired to be reproduced and desired number of times of repeating the reproduction of each speech data group are inputted by depression of any push buttons 2a. The control circuit 12 operates to display the data of identification codes of the speech data groups and the number of times of repeating the reproduction of each speech data group on the LCD 3. The control circuit 12 further operates to order the speech synthesis circuit 14 to perform the speech synthesizing operation. The speech synthesis circuit 14 reads out the speech data group corresponding to the identification code inputted from the IC memory 9 of the IC card 8 and performs speech synthesizing operation based on the speech data group read out, thereby producing analog speech signal Sa, which is supplied to the amplifying circuit 15. Speech is then reproduced from the earphone 7. Upon completion of the speech reproduc tion, a completion signal is supplied from the speech synthesis circuit 14 to the control circuit 12, which operates to repeat the above-described speech reproducing operation by the number of times previously set by depression of the push button 2a of the input section 2.

When any push button 2a of the input section 2 is depressed so that the continuous reproduction mode is selected the user may input data of desired identification code and desired number of times of repeat operation and then may select either FORWARD or REVERSE reproduction. The control circuit 12 operates to supply the speech synthesis circuit 14 with the identification codes starting with the one inputted and going forwardly when the FORWARD mode is selected, While under the REVERSE mode, the control circuit 12 operates to supply the speech synthesis circuit 14 with the identification codes starting with the one inputted and going reversely. Consequently, the speech synthesis circuit 14 reads out data of speech groups corresponding to the identification codes supplied thereto from the IC memory 9 of the IC card 8, thereby obtaining analog speech signals Sa, which are supplied to the amplifying circuit 15. The speech groups are thus reproduced from the earphone 7 and repeated by number of times set.

In the continuous reproduction mode, the control circuit 12 accesses data of the address corresponding to the identification code of the speech data group to be reproduced next. When data of the reproduction prohibition code is not stored with respect to the accessed data, the identification code is supplied to the speech synthesis circuit 14. Accordingly, when the reproduction prohibition code data is previously stored at the area of the built-in memory 13 by inputting the identification code(s) of the speech data group(s) not desired to be reproduced by depression of any push button 2a of the input section 2, each speech data group corresponding to the inputted identification code may be skipped over and the next speech data group for which the reproduction prohibition code is not inputted may be reproduced.

The language speaking trainer of the second embodiment permits the speech data groups to be reproduced with any of the groups skipped over. Consequently, when the identification code of the speech data group not desired to be reproduced is previously inputted by depression of the push button 2a, the speech may be skipped over and the next speech for which the reproduction prohibition code is not inputted may be reproduced. Consequently. the speech data groups may be reproduced with high efficiency and the learner can devote himself or herself to the speaking practice.

Although the language speaking trainer of the second embodiment is arranged so that the reproduction prohibi bition code is stored at the address of the built-in memory 13 corresponding to the identification code of speech, the identification code of the speech not desired to be reproduced may be stored at a predetermined area of the built-in memory 13 and the control circuit 12 may access the predetermined area of the memory 13 so that the speech synthesis circuit 14 performs speech reproducing operation with respect to the speech, the identification code data of which is not stored at the area of the built-in memory 13, as shown in Fig. 5. In this modification, as shown, data of the number of speech data groups not desired to be reproduced may also be stored at the builtin memory 13, thereby displaying data of the number of speech groups not desired to be reproduced on the LCD 3.

Although the language speaking trainer of each above-described embodiment is applied to the language speaking practice of any foreign language, it may be applied to the speaking practice of the mother tongue.

Although the invention is applied to reproduction of human speech in the foregoing embodiments, the invention may be applied to reproduction of other sounds.

The foregoing disclosure and drawings are merely illustrative of the principles of the present invention and are not to be interpreted in a limiting sense. The only limitation is to be determined from the scope of the appended claims.

**Claims**

1. A digital sound data storing device wherein digital sound data stored at an IC memory (9) is read out and synthesized by a sound synthesis circuit (14) into an analog sound signal which is amplified by an amplifying circuit (15) and reproduced as sound by an output means (7), characterized in that a card-shaped external storage unit (8) incorporating the built-in IC memory (9) storing a plurality of digitized sound data groups corresponding to a plurality of sound groups is detachably attached to a case (1) and that a reproduction unit (1a) enclosed by said case (1) comprises input means (2) for inputting an identification code corresponding to each sound group to be reproduced, internal storage means (13) for storing a reproduction information with respect to each sound data group corresponding to the identification code inputted at said input means (2), and selective reproduction control means (12) for controlling said sound synthesis circuit (14) so that each sound data group indicated by the reproduction information stored at said internal storage means (13) is sequentially synthesized to an analog sound signal.

2. A digital sound data storing device wherein digital sound data stored at an IC memory (9) is read out and synthesized by a sound synthesis circuit (14) into an analog sound signal which is amplified by an amplifying circuit (15) and reproduced as sound by an output means (7), characterized in that a card-shaped external storage unit (8) incorporating the built-in IC memory (9) storing a plurality of digitized sound data groups corresponding to a plurality of sound groups is detachably attached to a case (1) and that a reproduction unit (1a) enclosed by said case (1) comprises means (2) for inputting an identification code corresponding to each sound group undesired to be reproduced, internal storage means (13) for storing a reproduction information with respect to each sound data group corresponding to the identification code inputted at said input means (2), and selective reproduction control means (12) for controlling said sound synthesis circuit (14) so that the sound data groups stored at the IC memory (9) of said external storage unit (8) are sequentially read out in a continuous reproduction mode and are synthesized to analog sound signal, said selective reproduction control means (12) further controlling said sound synthesis circuit (14) so that in the continuous reproduction modes analog sound signals are synthesized based on the sound data groups except those corresponding to the sound groups set at said input means (2).

0294201

Fig.1

Fig.2

0294201

| Address | |
|---------|---|
| 00000 | First speech data store start address XXXXX<br>Second speech data store start address YYYYY<br>N-th speech data store start address ZZZZZ |
| XXXXX | First speech data |
| YYYYY-1 | End of the first speech data |
| YYYYY | Second speech data |
| ZZZZZ-1 | End of the (n-1)th speech data |
| ZZZZZ | N-th speech data |

Fig. 3

| Address | |
|---------|---|
| 0000 | Total of registered sentence numbers |
| 0001 | Registered sentence number |
| | Registered sentence number |

Fig. 4

| Address | |
|---------|---|
| 00 | First reproduction information |
| 01 | Second reproduction information |
| | N-th reproduction information |

Fig. 5